# EUROPÄISCHE PATENTSCHRIFT

(11) **EP 2 670 615 B1**
(45) Veröffentlichungstag und Bekanntmachung des Hinweises auf die Patenterteilung: **12.11.2014**
(21) Anmeldenummer: 12705048.2
(22) Anmeldetag: 01.02.2012
(51) Int. Cl.: B60K 35/00, B60R 16/00, B60K 37/06, G06F 3/048

(54) **VORRICHTUNG ZUR BEDIENUNG MEHRERER UNTERSCHIEDLICHER FUNKTIONEN EINES KRAFTFAHRZEUGS**
DEVICE FOR CONTROLLING MULTIPLE DIFFERENT FUNCTIONS OF A MOTOR VEHICLE
SYSTÈME SERVANT À COMMANDER PLUSIEURS FONCTIONS DIFFÉRENTES D'UN VÉHICULE AUTOMOBILE

(30) Priorität: 03.02.2011 DE 102011010229
(43) Veröffentlichungstag der Anmeldung: 11.12.2013
(73) Patentinhaber: Audi AG, 85045 Ingolstadt (DE)
(72) Erfinder: BECKER, Christian, 85049 Ingolstadt (DE); MERK, Imanuel, 22.251-040 Botafogo Rio de Janeiro (BR); VAN TUIJL, Mattijs, 85049 Ingolstadt (DE)
(74) Vertreter: Brandt, Kai
(86) Internationale Anmeldenummer: PCT/EP2012/000435
(87) Internationale Veröffentlichungsnummer: WO 2012/104070

(56) Entgegenhaltungen:
- DE-A1-102004 014 748
- DE-A1-102007 039 442
- DE-A1-102009 031 649
- US-A1- 2008 249 682

## Beschreibung

Die Erfindung betrifft eine Vorrichtung zur Bedienung mehrerer unterschiedlicher Funktionen eines Kraftfahrzeugs, mit einer berührungssensitiven Anzeigefläche, auf der zumindest ein Teil der bedienbaren Funktionen mittels jeweiliger, der jeweiligen Funktion zugeordneten Symbolen anzeigbar sind, nach der im Oberbegriff von Anspruch 1 näher definierten Art.

Eine gattungsgemäße Vorrichtung ist aus der DE 10 2007 039 442 A1 bekannt. Hierbei bilden mehrere, jeweiligen Einrichtungen des Fahrzeugs zugeordnete Objekte einen virtuellen Ring, der auf einem Display dargestellt ist.

Die US 2008/0249682 A1 beschreibt eine ähnliche Vorrichtung mit einem Display, das auf verschiedene Arten konfigurierbar ist.

Die gattungsbildende DE 10 2007 005 026 A1 beschreibt eine Anzeige- und Bedienvorrichtung, mit der eine einfachere und intuitivere Benutzung von unterschiedlichen Fahrzeugfunktionen möglich sein soll. Dazu sind Anzeige- und Bedienkontexte in einer geschlossenen Kette miteinander verknüpft und können mittels Drück- oder Drehregler bewegt werden. Diese bekannte Vorrichtung erfordert jedoch eine recht große Anzahl an Bedienelementen, was deren Bedienung erheblich erschwert.

Es ist daher Aufgabe der vorliegenden Erfindung, eine Vorrichtung zur Bedienung mehrerer unterschiedlicher Funktionen eines Kraftfahrzeugs zu schaffen, welche eine möglichst geringe Anzahl an Bedienelementen aufweist und dennoch möglichst intuitiv bedient werden kann.

Erfindungsgemäß wird diese Aufgabe durch die in Anspruch 1 genannten Merkmale gelöst.

Die erfindungsgemäße Vorrichtung ermöglicht zum Einen eine sehr einfache Bedienung und erfordert zum Anderen eine äußerst geringe Anzahl an Bauteilen, nämlich lediglich die Anzeigefläche und das wenigstens eine Bedienelement, was zu einem sehr geringen Raumbedarf der erfindungsgemäßen Vorrichtung führt und damit eine gute Integrierbarkeit derselben in den Innenraum eines Kraftfahrzeugs ermöglicht. Auch die mechanische Komplexität der Vorrichtung kann aufgrund der geringen Anzahl an Bauteilen verringert werden, wodurch sich auch die Anzahl an Fugen verringert, so dass ein sehr gefälliges Design möglich ist. Durch die geringe mechanische Komplexität lässt sich vorteilhafterweise auch die Fertigung der erfindungsgemäßen Vorrichtung vereinfachen, was zu geringeren Herstellkosten führt. Ein weiterer Vorteil der erfindungsgemäßen Vorrichtung besteht in deren guter Übersichtlichkeit aufgrund der geringen Anzahl an Bauteilen.

Erfindungsgemäß ist des Weiteren vorgesehen, dass das Bedienelement in wenigstens zwei unterschiedliche Richtungen bedienbar ist, um die ausgewählte Funktion auf unterschiedliche Weise zu bedienen. Eine solche Ausführung des Bedienelements ist vorteilhaft, da die meisten Funktionen des Kraftfahrzeugs, die vom Innenraum aus bedient werden, in zwei unterschiedlichen Richtungen bedient werden können, wie dies beispielsweise bei der Einstellung einer Temperatur, der Stärke oder Verteilung eines Gebläses oder auch der Einstellung einer Lautstärke der Fall ist.

Eine besonders einfache da intuitive Bedienung der erfindungsgemäßen Vorrichtung ergibt sich dadurch, dass die Bedieneinrichtung und/oder das Bedienelement zum Bedienen der ausgewählten Funktion um eine Drehachse drehbar gelagert ist. Insbesondere ist auf diese Weise auch die Bedienbarkeit in den zwei unterschiedlichen Richtungen gewährleistet.

Vorteilhafte Ausgestaltungen und Weiterbildungen der Erfindung ergeben sich aus den Unteransprüchen. Nachfolgend sind Ausführungsbeispiele der Erfindung anhand der Zeichnung prinzipmäßig dargestellt.

Es zeigt:
- Fig. 1: eine Draufsicht auf die erfindungsgemäße Vorrichtung in einem ersten Bedienzustand;
- Fig. 2: die Vorrichtung aus Fig. 1 in einem zweiten Bedienzustand;
- Fig. 3: die Vorrichtung aus Fig. 1 in einem dritten Bedienzustand;
- Fig. 4: die Ausführungsform der Bedieneinrichtung der erfindungsgemäßen Vorrichtung;
- Fig. 5: eine zweite nicht-erfindungsgemäße Ausführungsform der Bedieneinrichtung; und
- Fig. 6: eine dritte nicht-erfindungsgemäße Ausführungsform der Bedieneinrichtung

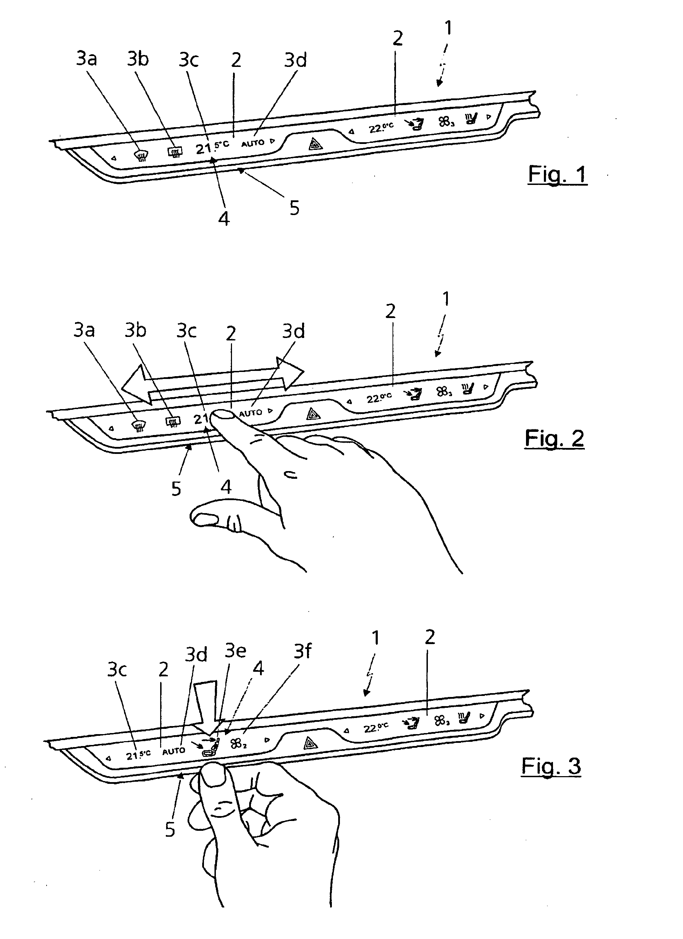

Fig. 1 zeigt eine Vorrichtung 1, die zur Bedienung mehrerer unterschiedlicher Funktionen eines Kraftfahrzeugs dient und vorzugsweise in einer Mittelkonsole oder an einer ähnlichen Stelle im Innenraum des Kraftfahrzeugs angeordnet ist. Die Vorrichtung 1 weist wenigstens eine, im vorliegenden Fall zwei voneinander beabstandete Anzeigeflächen 2 auf, auf denen während des Betriebs der Vorrichtung 1, der üblicherweise mit dem Betrieb des Kraftfahrzeugs zusammenfällt, zumindest ein Teil der mit der Vorrichtung 1 bedienbaren Funktionen mittels jeweiliger Symbole 3 angezeigt werden, die der jeweiligen zu bedienenden Funktion zugeordnet sind. Da die Funktion der beiden Anzeigeflächen 2 im wesentlichen identisch sind, wird nachfolgend lediglich die linke, dem Fahrer des Kraftfahrzeugs zugerichtete Anzeigefläche 2 beschrieben, während die rechte, dem Beifahrer zugerichtete Anzeigefläche 2 nicht näher beschrieben wird.

Im vorliegenden Fall sind auf der linken Anzeigefläche 2 ein Symbol 3a für eine Heizung einer Frontscheibe, ein Symbol 3b für eine Heizung einer Heckscheibe, ein Symbol 3c für eine Innenraumtemperatur und ein Symbol 3d für einen Automatikbetrieb einer Klimaanlage zu erkennen. Selbstverständlich sind die dargestellten Symbole 3a bis 3d lediglich als beispielhaft anzusehen und es können die verschiedensten anderen Funktionen mittels entsprechender Symbole 3 auf der Anzeigefläche 2 dargestellt und wie nachfolgend näher beschrieben mit der Vorrichtung 1 bedient werden. Insbesondere können auch andere Einrichtungen des Kraftfahrzeugs mit der Vorrichtung 1 bedient werden, wie zum Beispiel ein Navigationsgerät, ein Radio bzw. andere Unterhaltungsgeräte oder auch verschiedene Assistenzsysteme des Kraftfahrzeugs.

Die Anzeigefläche 2 ist berührungssensitiv ausgeführt und die Symbole 3 können mittels einer kombinierten Berühr- und Verschiebebewegung auf der Anzeigefläche 2 bewegt werden, um die jeweils zu bedienende Funktion an eine feste, mit dem Bezugszeichen 4 bezeichnete Bedienposition, deren Bedeutung zu einem späteren Zeitpunkt erläutert wird, auf der Anzeigefläche 2 zu bringen. Die Bedienposition 4 befindet sich vorzugsweise in einem mittleren Bereich der Anzeigefläche 2. Die Vorrichtung 1 kann eine Funktion aufweisen, gemäß welcher ein bestimmtes der Symbole 3 nach einer bestimmten Zeit auf die Bedienposition 4 zurückgefahren wird, beispielsweise das der Innenraumtemperatur zugeordnete Symbol 3c. Das Verschieben der Symbole 3 auf der Anzeigefläche 2 ist aus einem Vergleich der Figuren 2 und 3 zu erkennen und mit dem großen Pfeil in Fig. 2 angedeutet. Während sich bei dem Zustand gemäß Fig. 2 die oben genannten Symbole 3a, 3b, 3c und 3d auf der Anzeigefläche 2 befinden, wurden durch die Verschiebebewegung die Symbole 3a und 3b von der Anzeigefläche 2 nach links heruntergeschoben und es wurden zugleich zwei weitere Symbole, nämlich ein Symbol 3e für die Verteilung der Belüftung im Innenraum des Kraftfahrzeugs und ein Symbol 3f für die Stärke eines Gebläses von rechts auf die Anzeigefläche 2 geschoben. Während sich bei dem Zustand von Fig. 2 das Symbol 3c für die Höhe der Temperatur auf der Bedienposition 4 befand, befindet sich bei dem Zustand gemäß Fig. 3 das Symbol 3e für die Gebläseverteilung auf der Bedienposition 4. Es ist des weiteren zu erkennen, dass die jeweilige, sich auf der Bedienposition 4 befindliche Funktion auf der Anzeigefläche 2 optisch hervorgehoben dargestellt ist. In dem Zustand gemäß Fig. 1 und Fig. 2 ist also das Symbol 3c hervorgehoben dargestellt, während bei dem Zustand gemäß Fig. 3 das Symbol 3e hervorgehoben dargestellt ist. Im vorliegenden Fall wird dies durch eine Vergrößerung des Symbols 3c bzw. 3e erreicht, es sind jedoch auch andere Lösungen denkbar, z.B. eine hellere Darstellung des jeweiligen Symbols 3.

Im vorliegenden Fall werden auf der Anzeigefläche 2 vier Symbole gleichzeitig angezeigt. Um einerseits die Größe der Vorrichtung 1 gering zu halten und andererseits von dem Bediener möglichst wenig Verschiebebewegungen zu verlangen, ist es besonders vorteilhaft, wenn auf der Anzeigefläche 2 wenigstens drei Symbole 3 gleichzeitig angezeigt werden und wenn weitere Symbole 3 mittels der kombinierten Berühr- und Verschiebebewegung auf die Anzeigefläche 2 bewegt werden können, wie dies für die Symbole 3e und 3f oben beschrieben wurde.

Um die sich auf der Bedienposition 4 befindliche Funktion, im vorliegenden Fall also die durch das Symbol 3e dargestellte Gebläseverteilung, bedienen zu können, weist die Vorrichtung 1 eine von der Anzeigefläche 2 getrennte Bedieneinrichtung 5 auf, welche im Allgemeinen wenigstens ein benachbart zu der Bedienposition 4 angeordnetes Bedienelement 6 zum Bedienen der ausgewählten, d. h. sich auf der Bedienposition 4 befindlichen Funktion aufweist. Die Angabe "von der Anzeigefläche 2 getrennte Bedieneinrichtung 5" bezieht sich darauf, dass die Funktion nicht durch Berühren der Anzeigefläche 2 betätigt wird. Auch der zweiten Anzeigefläche 2 ist eine Bedieneinrichtung 5 mit wenigstens einem Bedienelement 6 zugeordnet. Das Bedienen der mit dem Symbol 3e verknüpften Funktion ist durch den großen Pfeil in Fig. 3 angedeutet.

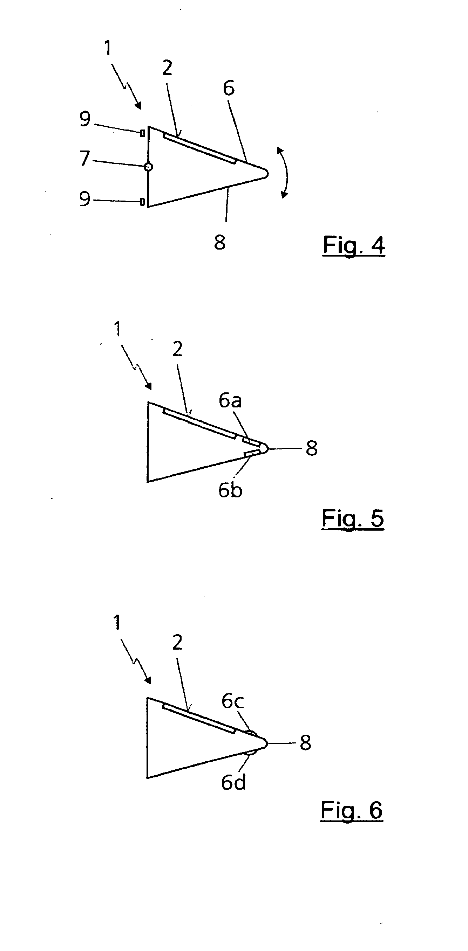

Die Figuren 4, 5 und 6 zeigen auf sehr schematische Weise unterschiedliche Ausführungsformen der Bedieneinrichtung 5. Sämtliche Ausführungsformen haben gemeinsam, dass das Bedienelement 6 in wenigstens zwei unterschiedliche Richtungen bedienbar ist, so dass beispielsweise die Temperatur in der einen Richtung erhöht und in der anderen Richtung verringert werden kann. Auch wenn die dem Symbol 3 zugeordnete Funktion nur ein- oder ausgeschaltet werden soll, kann eine solche Ausführung mit einem in zwei unterschiedliche Richtungen bedienbaren Bedienelement 6 vorteilhaft sein.

Bei der in Fig. 4 dargestellten erfindungsgemäßen Ausführungsform der Bedieneinrichtung 5 ist das Bedienelement 6 um eine Drehachse 7 drehbar gelagert, so dass die zu bedienende Funktion durch Drücken des Bedienelements 6 nach unten oder Ziehen desselben nach oben auf unterschiedliche Weise bedient werden kann, wie dies durch den Pfeil angedeutet ist. Die Bedieneinrichtung 5 weist einen zumindest um einen Teil der Anzeigefläche 2 umlaufenden Rahmen 8 auf, der bei der Ausführungsform von Fig. 4 das um die Drehachse 7 schwenkbare Bedienelement 6 bildet. In dem dargestellten Fall, in dem zwei Anzeigeflächen 2 vorgesehen sind, kann der Rahmen 8 das Bedienelement 6 für beide Anzeigeflächen 2 bilden. Der Rahmen 8 besteht vorzugsweise aus Metall, beispielsweise aus Aluminium oder Edelstahl, was dem Rahmen 8 nicht nur eine Langlebigkeit, sondern auch ein hochwertiges Aussehen verleiht. Die Bedieneinrichtung 5 weist des weiteren zwei dem Bedienelement 6 zugeordnete Schalter 9 auf, die durch das Verkippen des Bedienelements 6 betätigt werden und somit das durch die Bedienperson über das Bedienelement 6 eingeleitete Signal an eine nicht dargestellte Steuereinrichtung weitergeben. Durch die Schalter 9 kann dem Bediener außerdem eine akustische und/oder haptische Rückmeldung geboten werden.

Bei der nicht-erfindungsgemäßen Ausführungsform der Bedieneinrichtung 5 gemäß Fig. 5 sind auf dem Rahmen 8 auf einander gegenüberliegenden Seiten zwei berührungssensitive Bedienelemente 6a und 6b vorgesehen, die dazu dienen, die jeweilige Funktion zu bedienen. Beispielsweise kann das in diesem Fall obere Bedienelement 6a dazu dienen, die Temperatur, die Gebläseleistung, die Lautstärke oder eine andere Funktion zu erhöhen, während das an der Unterseite des Rahmens 8 angeordnete Bedienelement 6b dafür vorgesehen sein kann, die Größe der jeweiligen Funktion zu verringern.

Eine weitere nicht-erfindungsgemäße Ausführungsform der Bedieneinrichtung 5 der Vorrichtung 1 ist in Fig. 6 dargestellt. Hierbei sind auf gegenüberliegenden Seiten der Bedieneinrichtung 5, in diesem Fall des Rahmens 8 der Bedieneinrichtung 5, zwei als Taster ausgebildete Bedienelemente 6c und 6d vorgesehen. Die Bedienung der als Taster ausgebildeten Bedienelemente 6c und 6d kann auf ähnliche Weise erfolgen wie die Bedienung der berührungssensitiven Bedienelemente 6a und 6b von Fig. 5.

Bei den Ausführungsformen gemäß der Figuren 5 und 6 ist der Rahmen 8 bevorzugt steif ausgeführt. Auch bei den Ausführungen gemäß der Figuren 5 und 6 kann das Bedienelement 6 so ausgeführt sein, dass es dem Bediener eine akustische und/oder haptische Rückmeldung bietet, wobei insbesondere im Falle der berührungssensitiven Bedienelemente 6a und 6b zusätzliche Maßnahmen erforderlich sein können, um dies zu erreichen.

Die gesamte Vorrichtung 1 kann in der Art eines Moduls in den Innenraum des Kraftfahrzeugs integriert sein, wobei verschiedene Funktionen, die mit der Vorrichtung 1 bedient werden können, durch Verändern der jeweiligen Software integriert werden können. Mit einer solchen Softwareänderung kann auch die Anzahl und die Anordnung der Symbole 3 auf der Anzeigefläche 2 beeinflusst werden.

## Patentansprüche

1. Vorrichtung zur Bedienung mehrerer unterschiedlicher Funktionen eines Kraftfahrzeugs, mit einer berührungssensitiven Anzeigefläche (2), auf der zumindest ein Teil der bedienbaren Funktionen mittels jeweiliger, der jeweiligen Funktion zugeordneten Symbolen (3,3a,3b,3c,3d,3e,3f) anzeigbar sind, wobei die Symbole (3,3a,3b,3c,3d,3e,3f) mittels einer kombinierten Berühr- und Verschiebebewegung auf der Anzeigefläche (2) bewegbar sind, um die jeweils zu bedienende Funktion an eine feste Bedienposition (4) auf der Anzeigefläche (2) zu bringen, an der ein Bedienen der jeweiligen Funktion möglich ist, und mit einer von der Anzeigefläche (2) getrennten Bedieneinrichtung (5), welche wenigstens ein benachbart zu der Bedienposition (4) angeordnetes Bedienelement (6) zum Bedienen der ausgewählten Funktion aufweist,
**dadurch gekennzeichnet, dass**
das Bedienelement (6) in wenigstens zwei unterschiedliche Richtungen bedienbar ist, um die ausgewählte Funktion auf unterschiedliche Weise zu bedienen, wobei das Bedienelement (6) zum Bedienen der ausgewählten Funktion um eine Drehachse (7) drehbar gelagert ist.

2. Vorrichtung nach Anspruch 1,
**dadurch gekennzeichnet, dass**
die Bedienposition (4) sich in einem mittleren Bereich der Anzeigefläche (2) befindet.

3. Vorrichtung nach Anspruch 1 oder 2,
**dadurch gekennzeichnet, dass**
das jeweilige, sich auf der Bedienposition (4) befindliche Symbol (3,3a,3b,3c,3d,3e,3f) auf der Anzeigefläche (2) optisch hervorgehoben dargestellt ist.

4. Vorrichtung nach einem der Ansprüche 1 bis 3,
**dadurch gekennzeichnet, dass**
das Bedienelement (6) so ausgebildet ist, dass es dem Bediener eine akustische und/oder haptische Rückmeldung bietet.

5. Vorrichtung nach einem der Ansprüche 1 bis 4,
**dadurch gekennzeichnet, dass**
auf der Anzeigefläche (2) wenigstens drei Symbole (3,3a,3b,3c,3d,3e,3f) gleichzeitig anzeigbar sind, wobei weitere Symbole (3,3a,3b,3c,3d,3e,3f) mittels der kombinierten Berühr- und Verschiebebewegung auf die Anzeigefläche (2) bewegbar sind.

6. Vorrichtung nach einem der Ansprüche 1 bis 5,
**dadurch gekennzeichnet, dass**
zwei voneinander beabstandete Anzeigeflächen (2) mit jeweiligen Symbolen (3,3a,3b,3c,3d,3e,3f) und jeweiligen Bedieneinrichtungen (5) vorgesehen sind.

## Claims

1. Device for operating a plurality of different functions in a motor vehicle, having a touch-sensitive display panel (2) on which at least some of the operable functions can be displayed by respective symbols (3, 3a, 3b, 3c, 3d, 3e, 3f), each symbol being associated with the respective function, the symbols (3, 3a, 3b, 3c, 3d, 3e, 3f) being movable on the display panel (2) by a combined touch- and displacement movement in order to bring the respective function to be operated into a fixed operating position (4) on the display panel (2), in which operating position operation of the respective function is possible, and having an operating means (5) which is separate from the display panel (2) and comprises at least one operating element (6), arranged adjacent to the operating position (4), for operating the selected function, **characterised in that** the operating element (6) can be operated in at least two different directions to operate the selected function in different ways, the operating element (6) being rotatably mounted about an axis of rotation (7) to operate the selected function.

2. Device according to claim 1, **characterised in that** the operating position (4) is located in a central region of the display panel (2).

3. Device according to either claim 1 or claim 2, **characterised in that** the respective symbol (3, 3a, 3b, 3c, 3d, 3e, 3f) located in the operating position (4) is shown on the display panel (2) in a visually highlighted manner.

4. Device according to any of claims 1 to 3, **characterised in that** the operating element (6) is designed such that it provides the operator with acoustic and/or haptic feedback.

5. Device according to any of claims 1 to 4, **characterised in that** the display panel (2) can display at least three symbols (3, 3a, 3b, 3c, 3d, 3e, 3f) simultaneously, further symbols (3, 3a, 3b, 3c, 3d, 3e, 3f) being movable onto the display panel (2) by the combined touch- and displacement movement.

6. Device according to any of claims 1 to 5, **characterised in that** two display panels (2), spaced apart from one another, are provided with respective symbols (3, 3a, 3b, 3c, 3d, 3e, 3f) and respective operating means (5).

## Revendications

1. Dispositif de commande de plusieurs fonctions différentes d'un véhicule automobile, avec une surface d'affichage tactile (2), qui affiche au moins une partie des fonctions de commande au moyen de symboles (3, 3a, 3b, 3c, 3d, 3e, 3f) affectés à la fonction respective, dans lequel les symboles (3, 3a, 3b, 3c, 3d, 3e, 3f) peuvent être déplacés sur la surface d'affichage (2) au moyen d'un mouvement combiné de contact et de translation pour amener la fonction respectivement à commander en position de commande fixe (4) sur la surface d'affichage (2), sur laquelle une commande de la fonction respective est possible, et un dispositif de commande (5) séparé de la surface d'affichage (2), qui présente au moins un élément de commande (6) aménagé au voisinage de la position de commande (4) pour commander la fonction choisie,
**caractérisé en ce que** :
l'élément de commande (6) peut être commandé dans au moins deux directions différentes pour commander la fonction choisie de manière différente, dans lequel l'élément de commande (6) peut être monté à rotation autour d'un axe de rotation (7) pour commander la fonction choisie.

2. Dispositif selon la revendication 1,
**caractérisé en ce que** :
la position de commande (4) se trouve dans une zone centrale de la surface d'affichage (2).

3. Dispositif selon la revendication 1 ou la revendication 2,
**caractérisé en ce que** :
le symbole respectif (3, 3a, 3b, 3c, 3d, 3e, 3f) se trouvant dans la position de commande (4) est représenté optiquement accentué sur la surface d'affichage (2).

4. Dispositif selon l'une quelconque des revendications 1 à 3,
**caractérisé en ce que** :
l'élément de commande (6) est conformé de manière à offrir à l'utilisateur un accusé de réception acoustique et/ou haptique.

5. Dispositif selon l'une quelconque des revendications 1 à 4,
**caractérisé en ce que** :
on peut afficher simultanément au moins trois symboles (3, 3a, 3b, 3c, 3d, 3e, 3f) sur la surface d'affichage, dans lequel d'autres symboles (3, 3a, 3b, 3c, 3d, 3e, 3f) peuvent être déplacés sur la surface d'affichage (2) au moyen du mouvement combiné de contact et de translation.

6. Dispositif selon l'une quelconque des revendications 1 à 5,
**caractérisé en ce que** :
il est prévu deux surfaces d'affichage (2) séparées l'une de l'autre avec des symboles respectifs (3, 3a, 3b, 3c, 3d, 3e, 3f) et des dispositifs de commande respectifs (5).
